# EUROPEAN PATENT APPLICATION

(11) **EP 2 535 946 A1**
(43) Date of publication of application: **19.12.2012**
(21) Application number: 11742281.6
(22) Date of filing: 10.02.2011
(51) Int. Cl.: H01L 31/042

(54) **SOLAR CELL MODULE AND PRODUCTION METHOD FOR SOLAR CELL MODULE**

(30) Priority: 12.02.2010 JP 2010029193
(71) Applicant: Mitsubishi Chemical Corporation, Chiyoda-ku Tokyo 100-8251 (JP)
(72) Inventor: FUNAYAMA, Katsuya, Mie 510-8530 (JP); KASHIWAGI, Takuya, Mie 510-8530 (JP); YONEYAMA, Takahiro, Mie 510-8530 (JP); MURAKI, Kazuhiro, Tokyo 100-8251 (JP); KOMATSU, Kenjiro, Tokyo 100-8252 (JP); KIKUCHI, Kouichi, Nagano 386-1212 (JP)
(74) Representative: HOFFMANN EITLE
(86) International application number: PCT/JP2011/052807
(87) International publication number: WO 2011/099538

(57) **Abstract**

The solar cell module having a configuration in which a solar cell is formed on the metal-resin composite substrate, and exhibiting excellent durability. The solar cell module 10 includes a metal-resin composite substrate 16 consisting of a resin layer 16A having a melting point of not less than 125 °C sandwiched between metal layers 16B; a lower encapsulation layer 15 and/or an adhesion layer 15B arranged on the metal-resin composite substrate 16; and a power generation element 13 including a power generation layer sandwiched between a couple of electrodes, and arranged on the lower encapsulation layer 16 or the adhesion layer 15B.

## Description

### TECHNICAL FIELD

The present invention relates to a solar cell module and a method of manufacturing a solar cell module.

### BACKGROUND ART

A material consisting of a core material, such as a PE (polyethylene) sheet, sandwiched between aluminum sheets has been used for a long time as a building material.

If a solar cell is formed on such material (denoted hereinafter as a metal-resin composite substrate), it follows that photovoltaic power generation can be done easily at various buildings. Therefore, a solar cell module (refer to, e.g., Patent Document 1) has been developed which is made by attaching a solar cell onto a material consisting of a PE sheet sandwiched between aluminum sheets using an adhesive agent. This solar cell module (which will hereinafter be called the conventional module) is, however, such that the solar cell separates easily from the metal-resin composite substrate while being processed. Also, the conventional module is such that, even if it is used in a raw form, the solar cell separates from the metal-resin composite substrate within a comparative short period of time.

### [Prior Art Reference]

Patent Document 1: Japanese Laid-Open Patent Application No. 2002-151718

### SUMMARY OF THE INVENTION

### Problems to be solved by the Invention

Such being the case, the objects of the present invention are to provide a solar cell module having a configuration in which a solar cell is formed on a metal-resin composite substrate, and exhibiting excellent durability, and to provide a method of manufacturing a solar cell module by which a solar cell module having a configuration in which a solar cell is formed on a metal-resin composite substrate, and exhibiting excellent durability can be manufactured easily.

### Means for solving the Problems

To accomplish the above object, a solar cell module according to the present invention includes a metal-resin composite substrate consisting of a resin layer having a melting point of not less than 125 °C sandwiched between metal layers; a lower encapsulation layer and/or an adhesion layer arranged on the metal-resin composite substrate; and a power generation element including a power generation layer sandwiched between a couple of electrodes, and arranged on the lower encapsulation layer or the adhesion layer.

That is, the solar cell module according to the present invention includes the metal-resin composite substrate consisting of the resin layer, the melting point of which is higher than that of PE film, i.e. 120 °C, sandwiched between metal layers, and hence can be subjected to thermal lamination at higher temperature than the laminating temperature for the conventional module. Since higher laminating temperature provides better adhesiveness between the metal-resin composite substrate and the solar cell, it can be said that the solar cell module of the present invention is the solar cell module that has a configuration in which a solar cell is formed on the metal-resin composite substrate, and exhibits excellent durability.

The solar cell module of the present invention may further include an upper encapsulation layer arranged on the power generation element; and a weather resistant layer arranged on the upper encapsulation layer. Moreover, for actualizing the solar cell module of the present invention, it is possible to insert another layer(s) between the metal-resin composite substrate and the lower encapsulation layer and/or the adhesion layer; or between the lower encapsulation layer and/or the adhesion layer and the power generation substrate; or between the power generation element and the upper encapsulation layer; or between the upper encapsulation layer and the weather resistant layer. Note that, examples of the another layer(s) are an adhesive agent layer, a foundation layer, a wavelength conversion layer, a UV absorption layer, a color control layer, a nonflammable layer, a buffer layer, etc.

On the occasion of actualizing the solar cell module of the present invention, it is desirable to configure the solar cell module so that the power generation element substrate is arranged on the lower encapsulation layer, the thickness of the upper encapsulation layer is not less than 30 µm and not more than 800 µm (more preferably not less than 60 µm and not more than 600 µm, still more preferably not less than 100 µm and not more than 400 µm, and particularly preferably not less than 150 µm and not more than 300 µm), and the thickness of the power generation element substrate is thinner than that of the upper encapsulation layer. The reason is that use of the upper encapsulation layer and the power generation layer having such thicknesses makes the upper encapsulation layer to function as a "layer which absorbs the difference in the expansion quantity of the weather resistant layer and layers under the upper encapsulation layer induced by module temperature change" and an "impact absorbing layer."

On the occasion of actualizing the solar cell module of the present invention, it is possible to construct the solar cell module so as to have a shape in which periphery thereof is bent toward a direction opposite to a direction of a light receiving surface so that it can be fixed on another member (a wall of a building, etc.) with ease. Moreover, it is possible to construct the solar cell module so as to have a shape that can cover (ornament) an intersection part of walls, etc., namely, a curved surface shape.

Moreover, there are various materials usable as the power generation element substrate of the solar cell module of the present invention. For example, it is possible to use, as the power generation element substrate, a metal foil, a resin film whose melting point is not less than 85 °C and not more than 350 °C, or a stack of a metal foil and a resin film whose melting point is not less than 85 °C and not more than 350 °C.

Furthermore, by a method of manufacturing a solar cell module according to the present invention, a solar cell module, which includes a metal-resin composite substrate, a lower encapsulation layer, and a power generation element including a power generation layer sandwiched between a couple of electrodes, is manufactured by stacking a component, as the metal-resin composite substrate, consisting of a resin layer having a melting point of not less than 125 °C sandwiched between metal layers, and other components of the solar cell module; and uniting the stacked components by thermal lamination. Consequently, by this manufacturing method, a solar cell module having a configuration in which a solar cell is formed on a metal-resin composite substrate and exhibiting excellent durability can be manufactured easily.

The method of manufacturing a solar cell module according to the present invention may be used to manufacture the solar cell module having a configuration that the metal-resin composite substrate, the lower encapsulation layer, a power generation element substrate, the power generation element, an upper encapsulation layer, and a weather resistant layer are stacked in this order.

### Effects of the Invention

According to the present invention, a solar cell module having a configuration in which a solar cell is formed on a metal-resin composite substrate, and exhibiting excellent durability can be realized.

### BRIEF DESCRIPTION OF DRAWINGS

FIG. 1A is a sectional view showing a principal part of a solar cell module of an embodiment of the present invention;
FIG. 1B is a sectional view showing a principal part of the solar cell module of the embodiment;
FIG. 1C is a sectional view of a principal part of the solar cell module of the embodiment;
FIG. 2 is a plan view for explaining an example of a configuration of the solar cell module of the embodiment;
FIG. 3 is an explanatory diagram of an example of a module obtained by processing the solar cell module of the embodiment;
FIG. 4 is an explanatory diagram of an example of an attachment method of the solar cell module of the embodiment;
FIG. 5 is an explanatory diagram of another example of a module obtained by processing the solar cell module of the embodiment;
FIG. 6 is a diagram showing results of super accelerated weather resistance test of the solar cell module of the first example of the present invention;
FIG. 7 is a diagram showing results of xenon light irradiation test of the solar cell module of the first example;
FIG. 8 is a diagram showing results of humidity freeze test of the solar cell module of the first example;
FIG. 9 is a diagram showing results of high temperature and high humidity test of the solar cell module of the first example;
FIG. 10 is a diagram showing results of super accelerated weather resistance test of the solar cell module of the second example of the present invention;
FIG. 11 is a diagram showing results of high humidity and high temperature test of the solar cell module of the second example;
FIG. 12 is a diagram showing evaluation results of the solar cell properties of the solar cell modules of third through fifth examples of the present invention; and
FIG. 13 is a diagram showing a configuration of the solar cell module of the sixth example of the present invention.

### EMBODIMENT OF THE INVENTION

An embodiment of the present invention will hereinafter be described in depth with reference to the drawings.

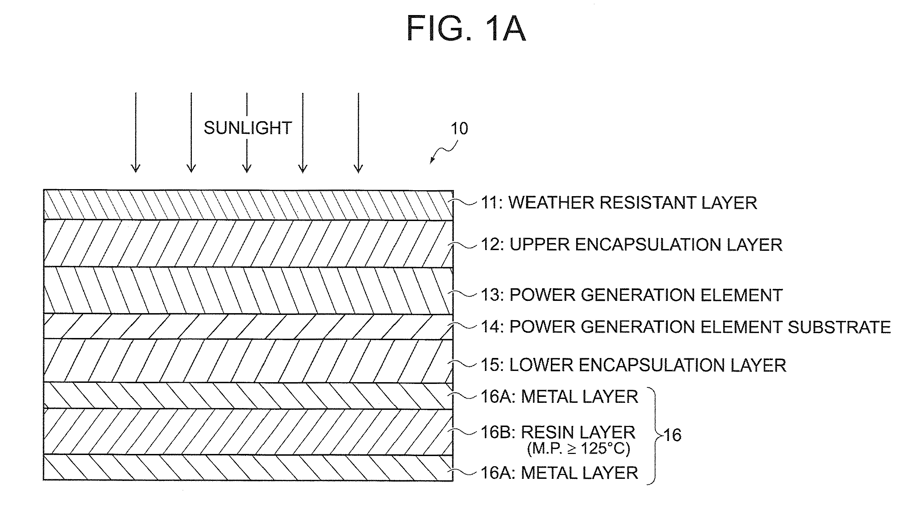

FIG. 1A through FIG. 1C each shows a sectional view of a principal part of the solar cell module 10 according to an embodiment of the present invention.

The solar cell module 10 according to the present embodiment has, as shown in FIG. 1A through FIG. 1C, such configuration (construction) that a weather resistant layer 11, a upper encapsulation layer 12, a power generation element 13, a power generation element substrate 14, a lower encapsulation layer 15 and/or an adhesion layer 15B, and a metal-resin composite substrate 16 are stacked in this order.

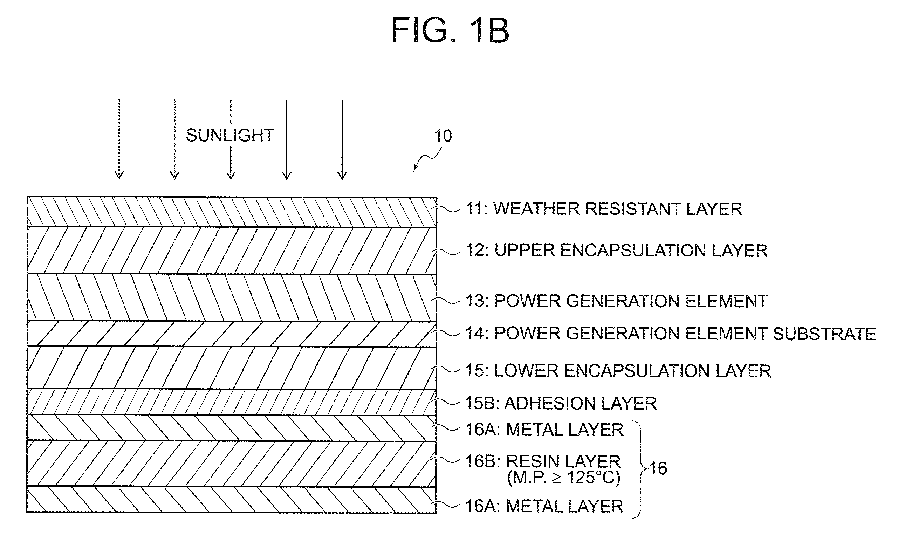

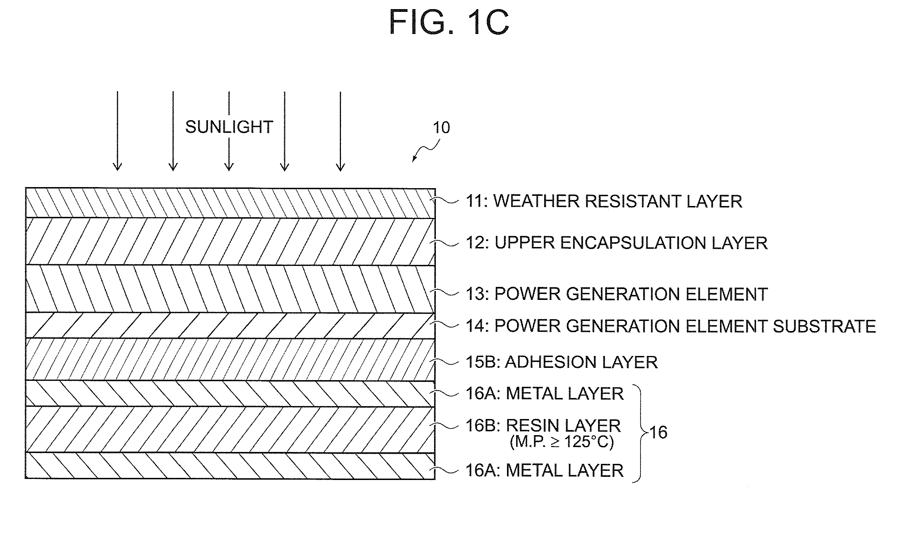

Note that, among components of the solar cell module 10 shown in FIGS 1A-1C, components indispensable to the solar cell module of the present invention are only the power generation element 13, the lower encapsulation layer 15 and/or the adhesion layer 15B, and the metal-resin composite substrate 16. That is, the solar cell module of the present invention may be actualized as the solar cell module (refer to FIG. 1A) that consists of only the power generation element 13, the lower encapsulation layer 15, and the metal-resin composite substrate 16; or the solar cell module (refer to FIG. 1B) that consists of only the power generation element 13, the lower encapsulation layer 15, the adhesion layer 15B and the metal-resin composite substrate 16; or the solar cell module (refer to FIG. 1C) that consists of only the power generation element 13, the adhesion layer 15B, and the metal-resin composite substrate 16; or the like.

### [Metal-Resin Composite Base Material 16]

The metal-resin composite substrate 16 used as a component of the solar cell module 10 is a material having such configuration that a resin layer 16B whose melting point is not less than 125 °C is sandwiched between a couple of metal layers 16A. Note that the solar cell module 10 has been developed on the assumption that it is manufactured (components thereof are unified) by thermal lamination (details are given later on). Since a higher melting point allows thermal lamination at a higher temperature, the solar cell module having greater durability (higher resistance to outdoor environment) can be obtained by using the resin layer 16B having a higher melting point. Consequently, the melting point of the resin layer 16B (the melting point of the resin that constitutes the resin layer 16B) is more preferably not lower than 135 °C, even more preferably not lower than 145 °C, and particularly preferably not lower than 155 °C. Moreover, in order to facilitate fabrication of the metal-resin composite substrate 16, the melting point of the resin layer 16B is preferably not higher than 290 °C, more preferably not higher than 250 °C, and particularly preferably not higher than 200 °C.

Various resins can be used as the constituent resin of the resin layer 16B. Specifically, polypropylene, polyethylene naphthalate, polybutylene terephthalate, polycarbonate, polyamide 6, polyamide 66, blend of two or more of these materials, and copolymer of two or more of these materials can be used as the constituent resin of the resin layer 16B, for example. Moreover, the constituent resin of the resin layer 16B may be the resin that contains one or more inorganic substances, such as phosphate ester compounds, halogenated compounds exemplified by chlorinated paraffins, antimony oxide, antimony hydroxide, barium borate, and glass fibers, or may be even the one that is foamed by some technique.

Thickness of the resin layer 16B should be determined on the basis of the physical properties of its constituent resin, and further in consideration of weight and mechanical strength of the metal-resin composite substrate 16 having a trade-offs relationship. The thickness of the resin layer 16B is, however, usually not less than 0.5 mm, preferably not less than 1 mm, more preferably not less than 1.5 mm, and most preferably not less than 2 mm. Moreover, the thickness of the resin layer 16B is usually not more than 30 mm, preferably not more than 20 mm, more preferably not more than 15 mm, and most preferably not more than 10 mm.

As each of the metal layers 16A of the metal-resin composite substrate 16, a sheet-shaped member made of aluminum, stainless steel, copper, titanium, iron, alloy of two or more of these materials, or the like, which is so-called a metal plate/foil, can be used. The thickness of the metal layer 16 should be also determined on the basis of the physical properties of its constituent resin. The thickness of the metal layer 16A is, however, preferably not less than 0.1 mm, more preferably not less than 0.2 mm, even more preferably not less than 0.3 mm, and most preferably not less than 0.4 mm. Moreover, the thickness of the metal layer 16A is preferably not more than 2 mm, more preferably not more than 1.5 mm, still more preferably not less than 1 mm, and most preferably not less than 0.8 mm.

The metal-resin composite substrate 16 may contain one or more layers (for example, an adhesive agent layer) other than the metal layer 16A and the resin layer 16B between the two layers. Moreover, method of fabricating the metal-resin composite substrate 16 is not particularly limited.

### [Power Generating Element 13]

The power generation element 13 is an element that generates electricity on the basis of the sunlight entered from the direction of the weather resistant layer 11. The power generation element 13 may be any element as long as it can convert light energy into electrical energy, and has a configuration that permits extraction of the electrical energy generated therein by the conversion.

It is therefore possible to use, as the power generation element 13 of the solar cell module 10, an element consisting of a power generation layer (a photoelectric conversion layer, a photoabsorption layer) sandwiched between a couple of electrodes; an element consisting of a stack of a power generation layer and another layer(s) (a buffer layer etc.) sandwiched between a couple of electrodes; an element consisting of such elements (which will be hereinafter referred to as cells) wired up in serial and/or parallel with one another; or the like.

Moreover, there are various layers that can be used as the power generation layer of the power generation element 13. However, it is preferred that the power generation layer be a layer consisting of an inorganic semiconductor material such as thin film single crystal silicon, thin film polycrystalline silicon, amorphous silicon, microcrystalline silicon, CdTe, Cu-In-(Ge)-Se, etc., an organic dye material such as a black dye, etc., an organic semiconductor material such as a conjugated polymer and a fullerene, etc., or the like. The reason is that, by using these materials, it is possible to obtain the element 13 of which a power generation efficiency (a photoelectric conversion efficiency) is relatively high and which has a thin thickness (a light weight).

Note that, in order to realize a still higher power generation efficiency, it is desirable to introduce a light trapping structure into the power generation element 13 or the solar cell module 10 by fabricating relief structures on the surface of the power generation layer or the power generation element substrate.

Moreover, by using an amorphous silicon layer as the power generation layer, the power generation element 13 with a large optical absorption coefficient in the visible region, which can fully absorb the sunlight even if its thickness is about 1 µm, can be actualized. Besides, since amorphous silicon, micro crystallite silicon, inorganic semiconductor materials, organic dye materials, and organic-semiconductor materials are noncrystalline materials or low crystalline materials, they have tolerance to the deformation. Consequently, by adopting the power generation element 13 including the amorphous silicon layer as the power generation layer, it is possible to actualize the solar cell module 10 which is especially lightweight, and also has a certain degree of tolerance to the deformation.

By using an inorganic semiconductor layer as the power generation layer, the power generation element 13 with a high power generation efficiency can be actualized. Note that, from the viewpoint of the power generation efficiency, it is preferred that the power generation layer be a chalcopyrite power generation layer containing a chalcogen element(s) such as S, Se, Te, etc., more preferably be I-III-VI2 group semiconductor (chalcopyrite) power generation layer, and most preferably be a Cu-III-VI2 group semiconductor power generation layer containing Cu as the group I element, especially the CIS semiconductor [CuIn (Se_{1-y}S_{y})₂; 0 ≤ y ≤ 1] layer or the CIGS semiconductor [Cu (Iₙ₁₋ₓGax) (Se_{1-y}Sy)₂; 0 < x < 1, 0 ≤ y ≤ 1] layer.

It is also possible to actualize the power generation element 13 with a high power generation efficiency by using as the power generation layer a dye-sensitized power generation layer consisting of a titanium oxide layer, an electrolyte layer, etc.

It is also possible to adopt an inorganic semiconductor layer (a layer containing p-type semiconductor and n-type semiconductor) as the power generation layer. Note that, examples of a p-type semiconductor of the organic semiconductor layer are: porphyrin compounds such as tetrabenzoporphyrin, tetorabenzo copper porphyrin, tetorabenzo zinc porphyrin, etc.; phthalocyanine compounds such as phthalocyanine, copper phthalocyanine, zinc phthalocyanine, etc; polyacenes such as tetracene, pentacene, etc.; oligothiophens such as sexithiophene; and derivatives containing these compounds as skeletons. Polymers such as polythiophene containing poly(3-alkylthiophene) or the like, polyfluorene, polyphenylene vinylene, poly triallyl amine, polyacetylene, polyaniline, polypyrrole, etc. are also examples of a p-type semiconductor layer of the organic semiconductor layer.

Examples of p-type semiconductor of the organic semiconductor layer are: fullerenes (C60, C70, and C76); octaazaporphyrin; perfluoro forms of the above-mentioned p-type semiconductors; aromatic carboxylic acid anhydrides such as naphthalenetetracarboxylic acid anhydride, naphthalenetetracarboxylic acid diimide, perylenetetracarboxylic acid anhydride, and perylenetetracarboxylic acid diimide; imide compounds of the aromatic carboxylic acid anhydrides; and derivatives containing these compounds as skeletons.

Examples of practical structure of the organic semiconductor layer are a bulk heterojunction type structure including a layer (i-layer) in which the p-type semiconductor and n-type semiconductor are phase-separated, a stacked type (hetero p-n junction type) structure in which a layer (p-layer) containing the p-type semiconductor and a layer (n-layer) containing the n-type semiconductor have an interface, a Schottky type structure, and combinations of these structures.

Each electrode of the power generation element 13 can be formed by using one or more arbitrary conductive materials. Examples of electrode material are: metals such as platinum, gold, silver, aluminum, chromium, nickel, copper, titanium, magnesium, calcium, barium, and sodium, or alloys thereof; metal oxides such as indium oxide and tin oxide, or their compound (ITO: Indium Tin Oxide); conductive polymers such as polyaniline, polypyrrol, polythiophene, and polyacetylene; materials obtained by adding dopants, for example, acids such as hydrochloric acid, sulfuric acid, and sulfonic acid, Lewis acids such as FeCl₃, halogen atoms such as iodine, and metal atoms such as sodium and potassium, to the above-mentioned conductive polymers; and conductive composite materials obtained by dispersing conductive particles such as metal particles, carbon black, fullerene, and carbon nanotubes in a matrix such as a polymer binder.

It is preferred that the electrode material be a material suitable for collecting holes or electrons. Examples of the electrode material suitable for collecting holes (in other words, high work function materials) are Au, Ag, Cu, ITO, IZO, ZnO₂ etc. Moreover, example of the electrode material suitable for collecting electrons (in other words, low work function material) is Al.

The fabrication method of electrodes is not especially limited. The electrodes can be therefore fabricated by either a dry process such vacuum deposition, sputtering, etc., or a wet process using conductive ink, and the like. Note that, as the conductive ink, an arbitrary material (a conductive polymer, a metal particle dispersion liquid, etc.) can be used.

Each electrode of the power generation element 13 may either be almost the same size as the power generation layer, or be smaller than the power generation layer. However, in a case where the electrode on the light receiving side (on the surface near the weather resistant layer 11) of the power generation element 13 is relatively large (is not smaller enough than the power generation layer), it should be an transparent (translucent) electrode, especially, an electrode whose optical transmittance over the wavelength range (300 nm - 1200 nm, preferably, 500 nm - 800 nm) where the power generation layer can efficiently converts the sun's energy into electrical energy is relatively high (for example, not less than 50 %). In addition, examples of the transparent electrode material are oxides such as ITO, IZO (indium oxide-zinc oxide), etc.; and metal thin films.

Moreover, although thicknesses of the electrode and the power generation layer of the power generation element 13 can be determined on the basis of the required output, etc., however, when too thick, an electric resistance may become large, and when too thin, there is a possibility that durability may fall.

### [Power Generating Element Substrate 14]

The power generation element substrate 14 is a member on a surface of which the power generation element 13 is formed. It is therefore desired that the power generation element substrate 14 have relatively high mechanical strength, be lightweight, and be excellent in weather resistance, heat resistance, water resistance, etc. The power generation element substrate 14 is also desired to have a certain degree of tolerance to deformation. However, in a case where physical properties (for example, coefficient of linear expansion, melting point, etc.) of the power generation element substrate 14 are markedly different from those of the power generation element 13, there is a possibility that distortion, exfoliation, etc. may occur in the interface between the power generation element substrate 14 and the power generation element 13 formed on the substrate 14.

It is therefore preferable to employ, as the power generation element substrate 14, a metal foil, a resin film whose melting point is 85-350 °C, or a stack of some foils and/or resin films.

Examples of the metal foil that can be used as the power generation element substrate 14 (or its component) are foils of aluminum, stainless steel, gold, silver, copper, titanium, nickel, iron, and alloys of these metals.

Examples of the resin film whose melting point is 85-350 °C are films of polyethylene; polypropylene; polystyrene; polyvinyl chloride; polyethylene terephthalate; polyethylenenaphthalate; polybutylene terephthalate; polycarbonate; polyacetal; acryl resin; polyamide resin; ABS resin; ACS resin; AES resin; ASA resin; copolymers of these resins; fluorocarbon resin such as PVDF, PVF, etc.; silicone resin; cellulose; nitrile resin; phenol resin; polyurethane; ionomer; polybutadiene; polybutylene; polymethylpenten; polyvinylalcohol; polyarylate; polyetheretherketone; polyetherketone; polyethersulfone; etc. Moreover, from the viewpoint of the productivity of the metal-resin composite substrate 16, it is desirable that the resin film be made of thermoplastic resin. In addition, the resin film used as the power generation element substrate 14 may be a film made by dispersing inorganic substances such as antimony oxide, antimony hydroxide, barium borate, and glass fibers, organic fibers, carbon fibers, etc. into one of the above-mentioned resins.

The reason why the melting point of the resin film used as the power generation element substrate 14 (or its component) is preferred to be 85 °C or more is that, when the melting point is too low, there is a possibility that the power generation element substrate 14 may deform under the usual operating environment of the solar cell module 10, giving damage to the power generation element 13. The reason why the melting point of the resin film is preferred to be 350 °C or less is that, when the melting point is too high, there is a possibility that the interface between the power generation element 13 and the power generation element substrate 14 is distorted due to temperature change and the like, causing separation of the power generation element 13 from the power generation element substrate 14.

Hence, the melting point of the resin film used as the power generation element substrate 14 (or its component) is more preferably not lower than 100 °C, further preferably not lower than 120 °C, still further preferably not lower than 150 °C, and most preferably not lower than 180 °C. Also, the melting point of the resin film is more preferably not higher than 300 °C, even more preferably not higher than 280 °C, and particularly preferably not higher than 250 °C.

Moreover, various test results has been revealed that the solar cell module 14 having the power generation substrate 14 thinner than the upper encapsulation layer 12 (details will be described later) could often cause cracks in the upper encapsulation layer 12, etc. when being bent. Therefore, the thickness of the power generation substrate 14 is preferably thinner than the upper encapsulation layer 12, and more preferably 0.83 (= 1/1.2) times as thick as the upper encapsulation layer 12 or less. Moreover, the thickness of the power generation substrate 14 is still more preferably 0.67 (= 1/1.5) times as thick as the upper encapsulation layer 12 or less, and particularly preferably 0.5 times as thick as the upper encapsulation layer 12 or less.

### [Upper Encapsulation Layer 12 and Lower Encapsulation Layer 15]

The upper encapsulation layer 12 and the lower encapsulation layer 15 are layers prepared in the solar cell module 10 for purposes of encapsulating the power generation element 13, joining the upper and lower layers, etc. However, each encapsulation layer 12 or 15 also contributes to the improvement in mechanical strength, weather resistance, gas barrier properties, etc. Moreover, it is desirable that, at least, the upper encapsulation layer 12 arranged at the light receiving surface side be a layer through which visible light permeates and which is highly resistant to heat. It is also possible to add another optical function(s) and/or mechanical function(s) to the upper encapsulation layer 12. Examples of the optical function are a light trapping function, a wavelength conversion function, etc., and examples of the mechanical function are a cushion function, etc.

Material for each of the encapsulation layers 12 and 14 should be selected in consideration of the above-mentioned matters. Practical examples of the material for each encapsulation layer 12 or 15 are ethylene-vinyl acetate copolymer (EVA) resins, polyolefin resins, AS (acrylonitrile-styrene) resins, ABS (acrylonitrile-butadiene-styrene) resins, polyvinyl chloride resins, fluorocarbon resins, polyester resins exemplified by a polyethylene terephthalate, a polyethylene naphthalate, etc., phenol-formaldehyde resins, polyacrylate resins, polymethacrylate resins, chloroprene resins, (hydrogenated) epoxy resins, polyamide resins represented by various nylons, polyimide resins, polyamide-imide resins, polyurethane resins, cellulose resins, silicone resins, polycarbonate resins, etc.

Among these, preferable resins are the ethylene copolymers, and more preferable resins are the ethylene-vinyl acetate copolymer (EVA) resins or the polyolefin resins that consist of ethylene and other olefins such as propylene-ethylene-α-olefin copolymers, ethylene-α-olefin copolymers, etc.

When preparing an EVA resin, in order to enhance the resistance to weather, a crosslinking agent to bride polymer chains is blended into an ethylene-vinyl acetate copolymer (EVA) resin compound. As the crosslinking agent, usually, an organic peroxide which produces radicals above 100 °C is used. Examples of the organic peroxide are 2,5-dimethyl hexane, 2,5-dihydro peroxide, 2,5-dimethyl-2,5-di(tert-butylperoxy)hexane, 3-di-tert-butylperoxide, etc. The blending quantity of the organic peroxide is usually 1 to 5 parts per weight to 100 parts by weight of the EVA resin. Moreover, the EVA resin compound may contain a crosslinking coagent.

It is possible to mix a silane coupling agent into EVA resin compound for the purpose of enhancing the adhesive strength, and/or to mix hydroquinone, etc, into the EVA resin compound for the purpose of enhancing stability.

As the propylene-ethylene-α-olefin copolymer, a thermoplastic resin compound that is a blend of a propylene polymer and a plasticized propylene polymer of suitable composition is usually used.

Each encapsulation layer 12 or 15 may be either a mixture of two or more of the above-mentioned materials or a stack of two or more different material layers. While the thickness of each encapsulation layer 12 or 15 is not particularly limited, from the viewpoint of flexibility to adjacent layers when module temperature changes, it is preferred that the thickness of the encapsulation layer 12 be 30 µm or more, further preferably be 60 µm or more, still further preferably be 100 µm or more. Moreover, when the upper encapsulation layer 12 is too thin, there is a danger that impact resistance will be spoiled. It is therefore preferred that the thickness of the upper encapsulation layer 12 be 800 µm or less, more preferably be 600 µm or less, still more preferably be 400 µm or less.

Although the thickness of the lower encapsulation layer 15 is not particularly limited, it is important that the lower encapsulation layer 15 can electrically insulate the power generation element 13. Therefore, it is preferred that the thickness of the lower encapsulation layer 15 be 10 µm or more, more preferably be 50 µm or more, and still more preferably be 100 µm or more. Furthermore, it is preferred that the thickness of the lower encapsulation layer 15 be 3 mm or less, more preferably be 1 mm or less, and still more preferably be 500 µm or less.

However, it is desirable to use the upper encapsulation layer 12 which is preferably 1 times or more, further preferably 1.5 times or more, still further preferably 2 times or more, and particularly preferably 2 times or more as thick as the power generation substrate 14. The reason why is that, as already mentioned, the solar cell module 14 having the power generation substrate 14 thinner than the upper encapsulation layer 12 could often cause cracks in the upper encapsulation layer when being bent.

### [Adhesion Layer 15B]

The adhesion layer 15B is a resin layer for binding the metal layer 16A and the lower encapsulation layer 15 or the power generation element substrate 14.
The constituent material (a resin used for forming the adhesion layer 15B) of this adhesion layer 15B may be any kind of resin (a thermoplastic resin, a thermosetting resin, a light hardening resin, etc.), as long as it adheres to the surfaces of the adherends with ease. Specifically, as the constituent material of the adhesion layer, a vinyl resin, a polyvinyl acetate resin, an olefin resin, an acrylic resin, an epoxy resin, an urethane resin, a nitrile rubber resin, a butadiene rubber resin, a chloroprene rubber resin, a silicone resin, or a mixture of two or more of these materials, a copolymer, or the like can be used. In addition, it is desirable to use a thermoplastic resin or a thermosetting resin such as an olefin resin, a nitrile rubber resin, a butadiene rubber resin, a chloroprene rubber resin, and a silicone resin as a constituent material of the adhesion layer 15B from the viewpoint of improving productivity. Moreover, from the viewpoint of improving durability of adhesive, it is desirable to use thermosetting resin such as an acrylic resin, an epoxy resin, a urethane resin, and a polyvinyl acetate resin; and an optical hardening resin as the constituent material of the adhesion layer 15B

If the film thickness of the adhesion layer 15B is too thin, there is a possibility that adhesiveness may weaken remarkably. Therefore, it is preferred that the film thickness of the adhesion layer 15B be 0.05 µm or more, more preferably be 0.1 µm or more, further preferably be 0.5 µm or more, and most preferably be 1 µm or more. Moreover, if the film thickness of the adhesion layer 15B is too thick, there is a possibility that adhesiveness may weaken when the adhesion layer 15B expands/contracts by a temperature change. Therefore, it is as for the film thickness of the adhesion layer 15B, it is desirable that it is 5 mm or less, it is more desirable that it is 1 mm or less, it is still more desirable that it is 0.5 mm or less, and it is most desirable that it is 0.1 mm or less.

The adhesion layer 15B is formed on the surfaces of the adherends before the laminating process, i.e., on the undersurface of the power generation element substrate 14 (refer to FIG. 1C), the undersurface of the lower encapsulation layer 15 (refer to FIG. 1B), and the upper surface of the metal resin composite substrate 16 (refer to FIG. 1B and FIG. 1C). When the adhesion layer 15B is formed on a member, it is possible to heat the adhesion layer 15B and this member. Moreover, when a light hardening resin is used as the adhesion layer 15B, it is possible to increase the adhesiveness of the adhesion layer 15B by light irradiation after lamination.

### [Weather-Resistant Layer 11]

The weather resistant layer 11 is a layer for giving mechanical strength, weather resistance, scratch resistance, chemical resistance, gas barrier properties, etc. to the solar cell module 10. It is preferable that the weather resistant layer 11 be the layer that does not disturb the photoabsorption of the power generation element 13, i.e., the one through which visible light permeates. More specifically, it is preferable that the weather resistant layer 11 be the layer whose transmittance over the wavelength range from 360 nm to 830 nm be 65 % or more, more preferably be 80 % or more, and particularly preferably be 90 % or more.

Moreover, since the solar cell module is heated by sunlight, it is desirable the weather resistant layer 11 have heat resistance. It is therefore preferable that the constitute material of the weather resistant layer 11 be the material whose melting point is 100 °C or more, and more preferably be the one whose melting point is 150 °C or more. Moreover, it is preferable that the constitute material of the weather resistant layer 11 be the material whose melting point is 320 °C or less, and more preferably be the one whose melting point is 250 °C or less.

The constitute material of the weather resistant layer 11 can be selected taking the above-mentioned matters into consideration. Examples of the constitute material of the weather resistance layer 11 are polypropylene resins, cyclic polyolefin resins, AS (acrylonitrile styrene) resins, ABS (acrylonitrile-butadiene-styrene) resins, polyvinyl chloride resins, fluorocarbon resins such as PFA, FEP, PCTFE, ETFE, ECTFE, PVDF, and PVF, polyester resins such as polyethylene telephthalate and polyethylene naphthalate, polyester resins exemplified by polyethylene terephthalate, polyethylene naphthalate, etc., phenol-formaldehyde resins, polyacrylate resins, polymethacrylate resins, chloroprene resins, (hydrogenated) epoxy resins, polyamide resins represented by various nylons, polyimide resins, polyamide-imide resins, polyurethane resins, cellulose resins, silicone resins, polycarbonate resins, etc.

Note that, as in the case of the encapsulation layers 12 and 15, the weather resistant layer 11 may be either a mixture of two or more of the above-mentioned materials or a stack of two or more different material layers.

Although the thickness of the weather resistance layer 11 is not limited, a decrease of the thickness usually results in a decrease of the mechanical strength, and an increase of the thickness usually results in an increase of the flexibility. Therefore, the thickness of the weather resistant layer 11 is usually 10 µm or over, preferably 15 µm or over, and more preferably 20 µm or over. Moreover, the thickness of the weather resistant layer 11 is usually 200 µm or less, preferably 180 µm or less, and more preferably 150 µm or less.

If the distance between the metal layer 16A and the power generation element substrate 14 is not less than 10 µm, electrical insulation between the power generation element 13 and the metal layer 16A can be provided. Therefore, it is preferred that the distance between the metal layer 16A and the power generation element substrate 14 be 10 µm or over, more preferably be 150 µm or over, and particularly preferable be 300 µm or over. Note that a large solar cell module (for example, 1 m² or more in size) generally has a wide variation in the film thickness. Therefore, in a case where the solar cell module is large, it is desirable that the distance between the metal layer 16A and the power generation element substrate 14 be rather long.

Excessively long distance between the metal layer 16A and the power generation element substrate 14 causes an increase in the manufacturing cost of the solar cell module. Therefore, it is desirable that the distance between the metal layer 16A and the power generation element substrate 14 be 800 µm or less, and particularly preferably be 700 µm or less.

### [Overall Configuration and Manufacturing Method of Solar cell Module 10]

As already mentioned, the solar cell module 10 has been developed on the assumption that it will be manufactured by thermal lamination. Furthermore, the solar cell module 10 is a module that can be manufactured by preparing every components (the weather resistant layer 11, the upper encapsulation layer 12, the power generation element 13, the power generation element substrate 14, the lower encapsulation layer 15 and/or the adhesion layer 15B) separately, and then uniting these by thermal lamination. However, preparing the power generation element 13 and the power generation element substrate 14 separately results in the difficulty to manufacture the solar cell module 10. It is therefore desirable to form the power generation element 13 on the power generation element substrate 14 before uniting the components of the solar cell module 10 by thermal lamination,

Incidentally, it is preferred that thermal lamination temperature be 100 °C or more, further preferably be 110 °C or more, and particularly preferably be 120 °C or more. Moreover, the thermal lamination temperature is preferable to be 180 °C or less, and more preferably be 170 °C or less. Furthermore, thermal lamination for manufacturing the solar cell module 10 may be a process that applies only heat to the stack. However, by using thermal vacuum and/or press lamination, the solar cell module 10 each layer of which bonded more strongly will be manufactured.

The solar cell module 10 shown in FIG. 1 does not include another layer between the upper encapsulation layer 12 and the power generation element 13. Also, it does not include another layer between the power generation element substrate 14 and the lower encapsulation layer 15 and/or the adhesion layer 15B. It is however possible, in order to enhance the optical and thermal functionality of the solar cell module 10, to insert a resin layer(s) which contributes to the improvement in adhesiveness, nonflammability, power generation performance, etc. between the upper encapsulation layer 12 and the power generation element 13, and/or between the power generation element substrate 14 and the lower encapsulation layer 15 and/or the adhesion layer 15B.

Moreover, the solar cell module 10 can be used in various forms. However, as evident from its configuration including the metal-resin composite substrate 16, the solar cell module 10 is easy to use especially as an exterior finish of a building, etc.

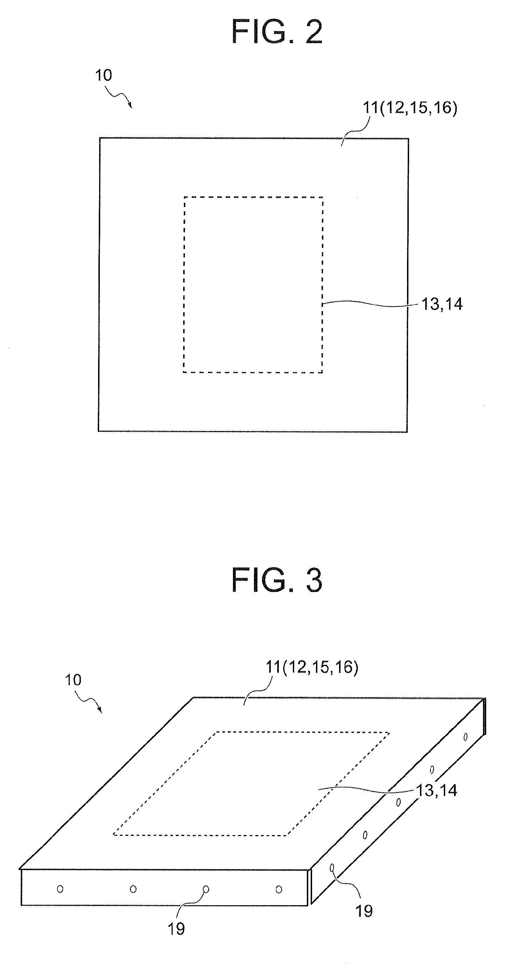

Furthermore, when using the solar cell module 10 as the exterior finish, it is better that the metal-resin composite substrate 16 (the metal layer 16A) is viewable from the viewpoint of an aesthetic appeal of the building, etc. Therefore, it is preferred that the solar cell module 10 is configured, as schematically shown in FIG. 2, so that the power generation element substrate 14 and the power generation element 13 are definitely smaller than other components (the metal-resin composite substrate 16 has the relatively large area that is not covered with the power generation element 13).

Note that, when the solar cell module 10 is manufactured as the module having the configuration illustrated in FIG. 2, it is possible to form the extraction electrodes (lead wires) for extracting a power from the power generation element 13 so as to either have a shape that extends from the power generation element 13 (usually, an edge of the power generation element 13) to an edge of the solar cell module 10 or have a shape that extends from the power generation element 13 to the thickness direction of the solar cell module 10 and comes out from the underside (the surface of the metal-resin composite substrate 16 which is not covered with the lower encapsulation layer 15, etc.) of the solar cell module 10.

Moreover, it is possible to manufacture the solar cell module 10 including the power generation element substrate 14 and the power generation element 13 arranged almost in the center thereof from the metal-resin composite substrate 16, the lower encapsulation layer 15 and/or the adhesion layer 15B, the upper encapsulation layer 12, and the weather resistant layer 11 of the same size, and the power generation element substrate 14 and the power generation element 13 that are smaller than the metal-resin composite substrate 16, etc., and then to process the solar cell module into the shape illustrated in FIG. 3. That is, it is possible to process the solar cell module 10 including the power generation element substrate 14 and the power generation element 13 having a small size into the shape where each side is bent to the counter direction toward the light receiving surface, and some module mounting holes 19 are formed at the side walls made by the bending.

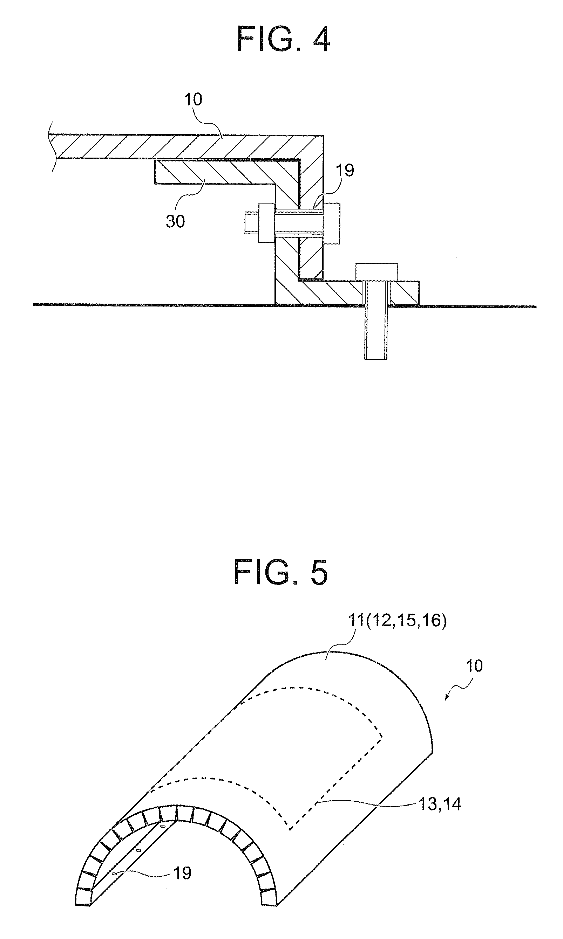

If the solar cell module 10 is processed into such shape, it follows that it is possible to install the solar cell module 10 in a desired place using a Z-shaped angle (crank-shaped fitting) 30 as schematically shown in FIG. 4.

Note that, when processing the solar cell module 10 into the shape illustrated in FIG. 3, it is preferable that the sum of the film thicknesses of the weather resistant layer 11, the upper encapsulation layer 12 and the lower encapsulation layer 15 is not less than 100 µm, more preferably be not less than 150 µm, still more preferable be not less than 300 µm, and especially preferably be not less than 500 µm. The reason is that, although an increase of the aforesaid sum results in an increase of durability (tolerance) against bending, it is possible to give practically sufficient durability to the solar cell module 10 if the aforesaid sum is 100 µm or more.

Moreover, regardless of whether or not the edges of the solar cell module 10 is processed, it is preferred that the sum of the film thicknesses of the weather resistant layer 11, the upper encapsulation layer 12 and the lower encapsulation layer 15 of the solar cell module 10 be not more than 3000 µm, and more preferably be not more than 2000 µm. Because, if the solar cell module 10 is thus manufactured, it is possible to prevent the manufacturing cost of the solar cell module 10 from going up vainly.

Moreover, it is possible to process the solar cell module 10 into the curved shape illustrated in FIG. 5, i.e., the shape that can cover (ornament) an intersection part of a wall, etc.

Incidentally, the curved shape into which the solar cell module 10 is processed may be a S-shape. Moreover, although the curved shape into which the solar cell module 10 is processed should be determined on the basis of a shape of a building to which the solar cell module 10 is attached, there is a possibility that processing the solar cell module 10 into the curved shape with an excessively small radius of curvature has a bad influence on the solar cell properties. Therefore, it is preferred that the radius of curvature of the curved shape into which the solar cell module 10 is processed be not less than 300 mm, more preferably not less than 500 mm, and particularly preferably be not less than 800 mm.

Processing the solar cell module 10 into the above-mentioned shape (FIG. 3, FIG. 5) can be done using a well-known machine tool/tool (a cutting machine, a roll bender, a rolling molding machine, a press brake, a drill, etc.). When processing the solar cell module 10 into the above-mentioned shape, it is preferable that the extraction electrodes be electrodes that extend from the power generation element 13 to the underside of the solar cell module 10. The reason is that, if the extraction electrodes extend from the power generation element 10 to an edge(s) of the solar cell module 10, there are a possibility that bending of the edge of the power generation element 10 causes the extraction electrodes to break, and there are also a possibility that the force applied to the power generation element 13 via the extraction electrodes damages the power generation element 13.

The present invention will be hereinafter discussed in detail by way of its examples and comparative examples.

### «First example, First Comparative Example and Second Comparative Example»

### [1] Configuration and manufacturing procedures of the first example, the first and second comparative examples

### [First Example]

The solar cell module of the 1st example of the present invention had the configuration shown in FIG. 1A, and was manufactured by the following procedures. Note that, in this specification, the solar cell module of the n-th example / comparative example (n = 1, 2, ...) connotes not one specific solar cell module, but the solar cell modules manufactured from the same materials and by the same procedures.

When manufacturing the solar cell module of the 1st example, first, aluminum (a backside electrode), an amorphous silicon layer (the power generation layer) and a translucent electrode were formed on a PEN (polyethylenenaphthalate) film of 50 µm in thickness, which serves as the power generation element substrate 14, thereby fabricating the power generation element substrate 14 on one surface of which the power generation element 13 was formed.

Moreover, an item consisting of a polypropylene resin (melting point: 165 °C) film having a thickness of 3.0 mm, which serves as the resin layer 16B, sandwiched between aluminum boards each having a thickness of 0.5 mm, which serve as the metal layers 16A, was prepared, and then the item was united by thermal lamination, thereby fabricating the metal-resin composite substrate larger than the power generation element 14.

Next, members thus fabricated, a 100-µm-thick ETFE film (100 HK-DCS available from AGC) as the weather resistant layer 11, a 300-µm-thick EVA film (F806 available from Hangzhou First PV Materials) as the upper encapsulation layer 12, a 300-µm-thick EVA film (the same as the above) as the lower encapsulation layer 15 were stacked in the order (and direction) shown in FIG. 1A, and then stacked films were united by thermal lamination (vacuum 5 min, applying pressure 5 min, holding 10 min) at 150 °C to manufacture the solar cell module of the 1st example.

Note that, as extraction electrodes of each of the solar cell module of the 1st example manufactured by the above-mentioned procedures and the solar cell modules which will be mentioned later, lead wires (Cu-O-100-4-R) available by Sanko Metal Industries were used. Moreover, the extraction electrodes of each solar cell module were arranged so that the electrical power can be extracted from the underside of the solar cell module.

### [First Comparative Example]

The solar cell module of the 1st comparative example was the module that differed from the above-mentioned solar cell module of the 1st example only in the point that a 3.0-mm-thick polyethylene resin (melting point: 110 °C) film was used as the resin layer 16B.

### [Second Comparative Example]

The solar cell module of the 2nd comparative example was the module that differed from the above-mentioned solar cell module of the 1st example (thermal lamination temperature: 150 °C) only in the point that thermal lamination was carried out at 120 °C.

### [2] Evaluation results of the solar cell modules of the 1st example and the 1st and 2nd comparative examples

The solar cell module of the 1st comparative example which includes a 3.0-mm-thick polyethylene resin film as the resin layer 16B (which includes a member consisting of a 3.0-mm-thick polyethylene resin film sandwiched with 0.5-mm-thick aluminum plates as the metal-resin composite substrate 16) and was manufactured by thermal lamination at 150 °C was the module wherein polyethylene resin melt protrudes from between the aluminum plates (the metal layers 16A). That is, the solar cell module of the 1st comparative example was the module that can hardly be sold as a product. The solar cell module of the 1st comparative example had large thickness distribution and remarkably bad appearance due to the protruded polyethylene resin, and was difficult to bent its edges and to transform its shape into a curved shape since the homogeneity of the module thickness was spoiled remarkably.

The solar cell modules of the 1st example and the 2nd comparative example each had a satisfactory appearance. However, from measurement results of adhesion strength between the lower encapsulation layer 15 and the metal layer 16A of each solar cell module by the 180 degree peel test based on Japan Industrial Standard (JIS) K6854-2, it was found that, while adhesion strength of the solar cell module of the 1st example was as high as 53 N/25mm, adhesion strength of the solar cell module of the 2nd comparative example was as low as 16 N/25mm.

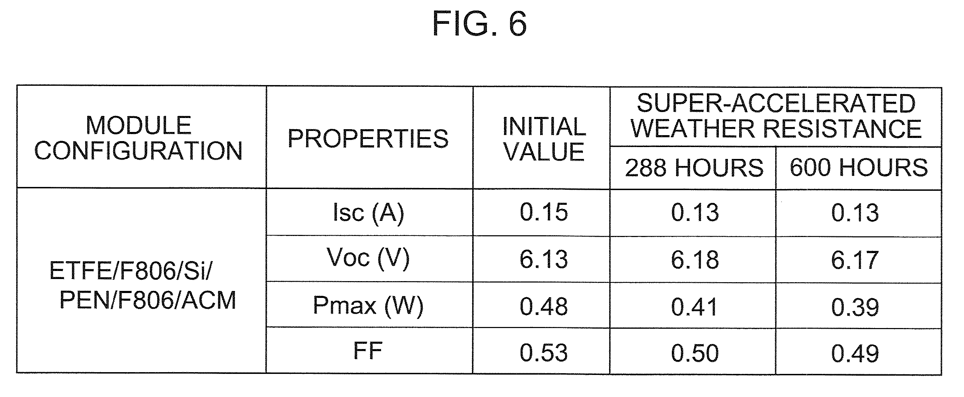

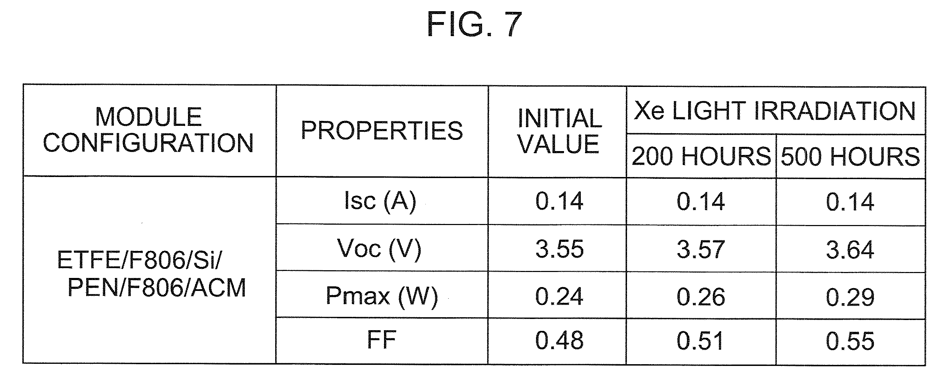

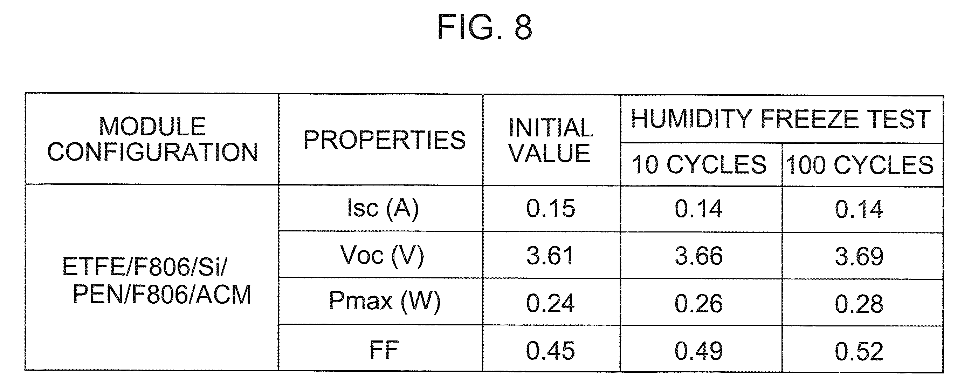

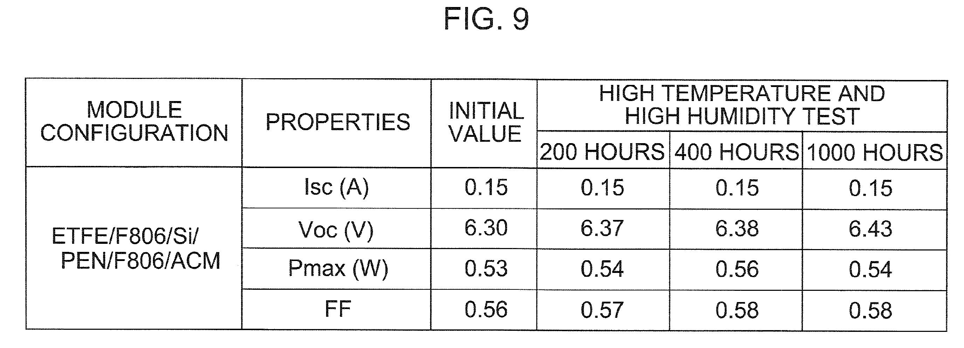

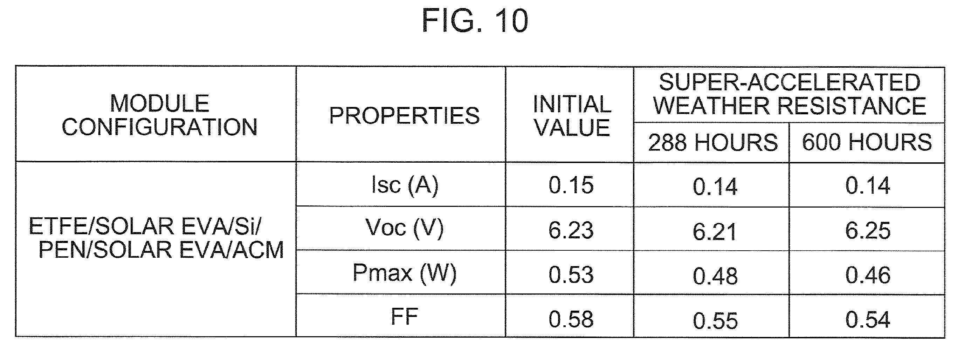

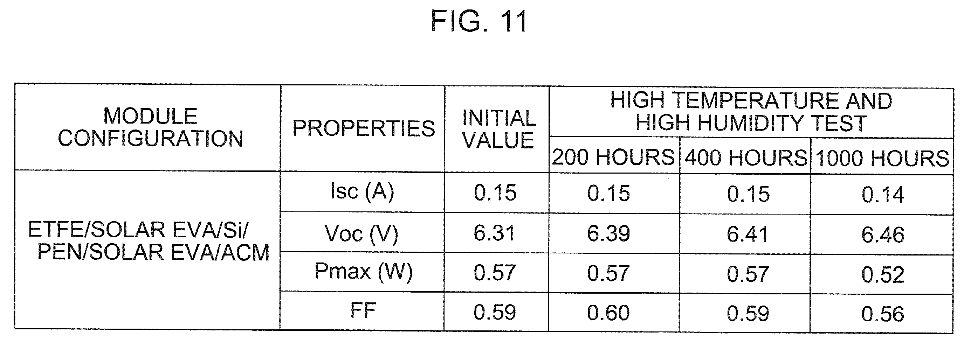

Moreover, as to the solar cell module of the 1st example, the test results shown in FIG. 6 - FIG. 9 were obtained. Note that, in these FIGS and FIGS. 10 and 11 which will be detailed later, "ACM" denotes the metal-resin composite substrate 16. Furthermore, the reason why short circuit currents (Isc's), open circuit voltages (Voc's), and maximum powers (Pmax's) in the solar cell properties (Isc, Voc, Pmax, and FF (Fill Factor)) shown in FIG. 7 and FIG. 8 are greatly different from those shown in FIGS. 6 and 9 is that the solar cell modules of which the power generation element substrate 14 differed in size were tested.

Among the test results shown in FIGS. 6 though 9, the test results shown in FIG. 6 include the solar cell properties of the solar cell module of the 1st example, which were measured with a solar simulator, after stabilizing the module by exposing it to light (radiant intensity: 1000 W/m²) within a metal halide lamp weather resistance tester by Iwasaki Electric Co., Ltd. for 24 hours (denoted hereinafter as "after light stabilization" and so on); after 288 hours exposure to light and water within an accelerated weather resistance tester (filter: KF-1 filter, radiant intensity at sample surface: 750 W/cm², black panel temperature: 63 °C, relative humidity: 50 %RH, water splay cycle: 2 min during 120 min irradiation) by Daipla Wintes Co.,Ltd.; and after 600 hours exposure to light and water within the same accelerated weather resistance tester.

The test results shown in FIG. 7 include the solar cell properties of the solar cell module of the 1st example, which were measured with the solar simulator, after light stabilization; after 200 hours exposure to xenon light within a xenon fade meter (a xenon lamp system, radiant intensity: 320 W/cm², black panel temperature: 63°C, relative humidity: 50 %RH) manufactured by Suga Test Instruments Co., Ltd., and after 500 hours exposure to xenon light within the same meter.

The test results shown in FIG. 8 include the solar cell properties of the solar cell module of the 1st example, which were measured with the solar simulator, after light stabilization, after a humidity freeze test for 15 cycles from 85°C, 85 %RH to -20°C at 6 hours per cycle, and after a humidity freeze test for 100 cycles from 85 °C, 85 %RH to -20 °C at 6 hours per cycle.

The test results shown in FIG. 9 include the solar cell properties of the solar cell module of the 1st example, which were measured with the solar simulator, after light stabilization, after 200 hours exposure to high temperature and high humidity (85 °C, 85 %), after 400 hours exposure to high temperature and high humidity (85 °C, 85 %), and after 1000 hours exposure to high temperature and high humidity (85 °C, 85 %).

Thus, it had been found that the solar cell module of the 1st example was the module having very good weather resistance (the module of which solar cell properties hardly change after a long weather resistant test/ light irradiation test/ humidity freeze test/ high temperature and high humidity test).

Therefore, it can be said that the configuration adopted to the solar cell module of the 1st example (namely, the configuration of the solar cell module of the present invention) is the configuration that can realize the solar cell module, which includes the metal-resin composite substrate and the solar cell, having excellent durability.

### «Second Example»

The solar cell module of the 2nd example was manufactured by the fundamentally same method as the above-mentioned solar cell module of the 1st example. However, as each of the upper encapsulation layer 12 and the lower encapsulation layer 15 of the solar cell module of the 2nd example, an EVA film (Solar EVA: SC52B, available from Mitsui Chemicals Fabro) of 400-µm thicknesses was used.

Further, the solar cell module of the 2nd example was thermal laminated on conditions as follows.

Temp. 150 °C, vacuum 2 min, applying pressure 5 min, holding 10 min.

In short, the solar cell module of the 2nd example was fabricated using the upper encapsulation layer 12 and the lower encapsulation layer 15 each thicker than that of the solar cell module of the 1st example, and a laminating process that is more severe (whose holding time at high temperature is longer) than that for the solar cell module of the 1st example.

The solar cell module of the 2nd example also had a satisfactory appearance and a very high weather resistance as shown in FIG. 10 and FIG. 11. Note that the adhesion strength between the lower encapsulation layer 15 and the metal layer 16A of the solar cell module of the 2nd example measured by above procedure/method was 50 N/25mm.

### «Third - Fifth Examples»

The solar cell module of the 3rd example of the present invention was an enlarged type of the above-mentioned solar cell module of the 1st example. More specifically, the solar cell module of the 3rd example was manufactured using the power generation element substrate 14 having dimensions 750 mm × 900 mm, the power generation element 13 having dimensions 750 mm × 900 mm and including 750 ×x 900 cells, and the metal resin composite substrate 16 having dimensions 937 mm × 1405 mm.

The solar cell module of the 4th example of the present invention was obtained by bending the four edges (50 mm width parts) of the solar cell module of the 3rd example towards the direction opposite to the direction of the light receiving surface (refer to FIG. 3).

The solar cell module of the 5th example of the present invention was obtained by bending the solar cell module of the 3rd example into a curved shape (refer to FIG. 4) with a radius of 1000 mm using a three roll bender.

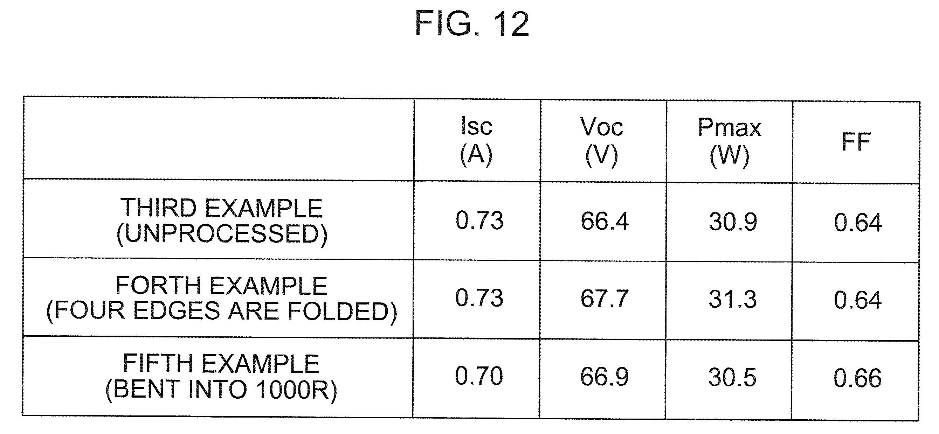

FIG. 12 shows the evaluation results of the solar cell properties of the solar cell modules of the 3rd through 5th examples. As obvious from these evaluation results, the configuration of the solar cell module of the 3rd example enables the module to be bent into a curved surface without causing solar cell properties, and also enables to be bent at lines near the edges without causing solar cell properties degradation.

### «Sixth Example»

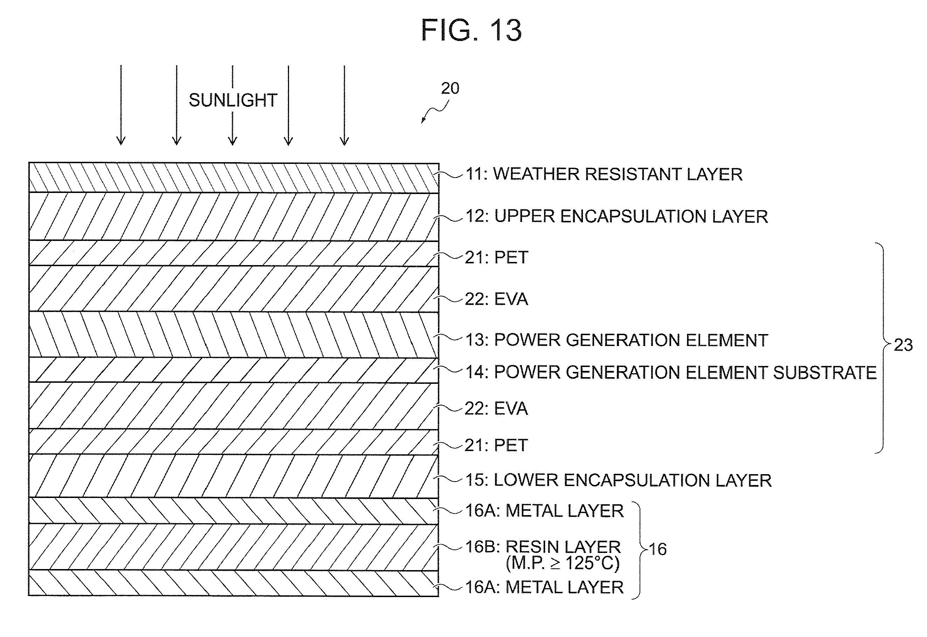

FIG. 13 shows a configuration of the solar cell module 20 of the 6th example of the present invention.

As obvious from a comparison between FIG. 13 and FIG. 1, the solar cell module 20 of the 6th example was the modified version of the solar cell module 10 of the 1st example so as to include "the resin sandwiched power generation element 23 that is a stack of the PET (polyethylene terephthalate) film 21, the EVA film 22, the power generation element 13, the power generation element substrate 14, the EVA film 22, and the PET film 21 stacked in this order" instead of "the power generation element 13 and the power generation element substrate 14."

More specifically, this solar cell module 20 was manufactured by the following method.

First, the PET film 21 of 100-µm thickness, the EVA film 22 (F806 available from Hangzhou First PV Material) of 300-µm thickness, the power generation element substrate 14 on which the power generation element 13 was formed, the EVA film 22 (the same as the above) of 300-µm thickness and the PET film 21 of 100-µm thickness were stacked in this order, and then thermal lamination at 150 °C was carried out to form the resin sandwiched power generation element 23.

Next, a 100-µm-thick ETFE film (100 HK-DCS available from AGC) as the weather resistant layer 11, a 300-µm-thick EVA film (F806 available from Hangzhou First PV Material) as the upper encapsulation layer 12, the formed resin sandwiched power generation element 23, a 300-µm-thick EVA film (F806 available from Hangzhou First PV Material) as the lower encapsulation layer 15, and the metal-resin composite substrate 16 (ALPOLIC available from MITSUBISHI PLASTICS: 200 mm × 200 nm) were stacked and bonded by thermal lamination (vacuum 5 min, applying pressure 5 min, and holding 10 min) at 150 °C to manufacture the solar cell module 20.

Thereafter, the mechanical strength and solar cell properties of the solar cell were evaluated. As a result, it was found that the solar cell module 20 had solar cell properties comparable as the solar cell module 10, and had mechanical strength higher than the solar cell module 10. In other words, it was found that it was not necessary to arrange only the power generation element 13 and the power generation element substrate 14 between the upper encapsulation layer 12 and lower encapsulation layer 15.

### INDUSTRIAL APPLICABILITY

The solar cell module of the present invention can be used as a building material for an exterior wall, an outer backpanel, a roof, etc., and a component of an automobile, interior design, a rail motor, a vessel, an airplane, a spacecraft, a home appliance, a portable cellular phone, and a toy. Moreover, the manufacturing method of manufacturing a solar cell module of the present invention is available to fabricate solar cell modules.

### DESCRIPTION OF THE REFERENCE NUMERALS

- 10, 20:: solar cell module
- 11:: weather resistant layer
- 12:: upper encapsulation layer
- 13:: power generation element
- 14:: power generation element substrate
- 15:: lower encapsulation layer
- 15B:: adhesion layer
- 16:: metal-resin composite substrate
- 16A:: metal layer
- 16B:: resin layer
- 19:: module mounting hole
- 23:: resin sandwiched power generation element
- 30:: angle

## Claims

1. A solar cell module, comprising:
a metal-resin composite substrate consisting of a resin layer having a melting point of not less than 125 °C sandwiched between metal layers;
a lower encapsulation layer and/or an adhesion layer arranged on the metal-resin composite substrate; and
a power generation element including a power generation layer sandwiched between a couple of electrodes, and arranged on the lower encapsulation layer or the adhesion layer.

2. The solar cell module according to claim 1, further comprising:
an upper encapsulation layer arranged on the power generation element; and
a weather resistant layer arranged on the upper encapsulation layer.

3. The solar cell module according to claim 1 or 2, further comprising a power generation element substrate arranged on the lower encapsulation layer,
wherein a thickness of the upper encapsulation layer is not less than 30 µm and not more than 800 µm, and
a thickness of the power generation element substrate is thinner than a thickness of the upper encapsulation layer.

4. The solar cell module according to any one of claims 1 through 3 having a shape in which periphery thereof is bent toward a side opposite to a light receiving surface.

5. The solar cell module according to any one of claims 1 through 4, wherein the power generation substrate is a metal foil, a resin film whose melting point is not less than 85 °C and not more than 350 °C, or a stack of a metal foil and a resin film whose melting point is not less than 85 °C and not more than 350 °C.

6. The solar cell module according to any one of claims 1 through 5 having a curved surface shape.

7. A method of manufacturing a solar cell module including a metal-resin composite substrate, a lower encapsulation layer, and a power generation element including a power generation layer sandwiched between a couple of electrodes, the method comprising:
stacking a component, as the metal-resin composite substrate, consisting of a resin layer having a melting point of not less than 125 °C sandwiched between metal layers, and other components of the solar cell module; and
uniting the stacked components by thermal lamination, whereby manufacturing the solar cell module.

8. The method according to claim 7, by which the solar cell module having a configuration that the metal-resin composite substrate, the lower encapsulation layer, a power generation element substrate, the power generation element, an upper encapsulation layer, and a weather resistant layer are stacked in this order is manufactured.
